# EUROPÄISCHE PATENTANMELDUNG

(11) **EP 0 612 859 A1**
(43) Veröffentlichungstag der Anmeldung: **31.08.1994**
(21) Anmeldenummer: 94102628.8
(22) Anmeldetag: 22.02.1994
(51) Int. Cl.: C23C 14/24, C23C 14/32, H01J 37/32

(54) **Niedervoltbogenverdampfer mit Nachfütterungseinrichtung und Verfahren zu dessen Verwendung**

(30) Priorität: 25.02.1993 DE 4305721
(71) Anmelder: VTD Vakuumtechnik Dresden GmbH, D-01257 Dresden (DE)
(72) Erfinder: Grimm, Werner, D-01326 Dresden (DE); Weber, Klaus, D-01219 Dresden (DE); Bücken, Bernd, D-01277 Dresden (DE); Cernohorsky, Hagen, D-01159 Dresden (DE)
(74) Vertreter: Pätzelt, Peter, Dipl.-Ing. Patentanwalt

(57) **Zusammenfassung**

Die Erfindung gibt einen Niedervoltbogenverdampfer an, bei dem das Verdampfungsmaterial von unten in die Verdampfungszone zugeführt wird und der bei geringem technischen Aufwand eine kontinuierliche Vakuumbeschichtung von Substraten ermöglicht. Der Niedervoltbogenverdampfer weist eine Führung (5) mit einer vertikalen Bohrung (12) auf, in der stabförmiges Verdampfungsmaterial (11) geführt und gehaltert wird. Die Führung (5) ist zur Vakuumkammer (1) elektrisch isoliert angeordnet und wassergekühlt. Außerhalb der Vakuumkammer (1) befindet sich die Nachfütterungseinrichtung, die eine gekühlte Aufnahme (21) für das stabförmige Verdampfungsmaterial (11) aufweist. Sie ist über einen Metallfaltenbalg (20) elektrisch isoliert mit der Vakuumkammer (1) mechanisch verbunden. Das stabförmige Verdampfungsmaterial (11) liegt über die Aufnahme (21) am anodischen Potential der Niedervoltbogenentladung.

Verfahrensgemäß können mit dem Niedervoltbogenverdampfer mehrere Materialien verdampft werden, die in einer Stab-Rohr-Kombination in die Verdampfungszone zugeführt werden.

## Beschreibung

Die Erfindung betrifft einen Niedervoltbogenverdampfer für die Beschichtung von Substraten in einer Vakuumkammer mit einer Nachfütterungseinrichtung, die das Verdampfungsmaterial von unten in die Verdampfungszone nachführt und ein Verfahren zur Abscheidung von Misch- oder Legierungsschichten auf Substraten im Vakuum mit diesem Niedervoltbogenverdampfer.

Nach dem Stand der Technik sind eine Reihe von Nachfütterungseinrichtungen für Verdampfungsmaterial, insbesondere in Durchlaufanlagen, bekannt. So kann das Material aus Drahtwickelvorräten innerhalb der Vakuumkammer kontinuierlich auf den Verdampfer geführt werden, wo es innerhalb des vorhandenen Schmelzbades bzw. direkt auf dem Verdampfer unter Einwirkung der jeweils eingesetzten Wärmequelle verdampft wird. Derartige Einrichtungen haben insbesondere den Nachteil, daß sie innerhalb der Vakuumanlage einen erheblichen Raumbedarf haben und für andere Einrichtungen bzw. den Beschichtungsvorgang selbst hinderlich sind. In ähnlicher Form können Nachfütterungseinrichtungen innerhalb der Beschichtungsanlage vorhanden sein, die pelletartiges Verdampfungsmaterial periodisch in den Verdampfungstiegel befördern.

Insbesondere für Induktionsverdampfer sind auch Nachfütterungseinrichtungen bekannt, bei denen das Verdampfungsmaterial stabförmig vertikal von unten in die Verdampfungszone eingeführt wird. Das Verdampfungsmaterial wird dabei in einer isoliert angeordneten Einrichtung gehalten.

Für den katodischen Vakuumbogen wird in der EP 0 516 425 A1 eine Vorrichtung beschrieben, mit der konstante Plasmabedingungen über die Beschichtungszeit erzielt werden sollen. Dazu wird ein relativ großes Target eingebracht, und eine Blende wird entsprechend der Verdampfung des Targets jeweils auf die Höhe dessen Oberkante nachgestellt.

Die bekannten Nachfütterungseinrichtungen sind alle nur ungenügend für den Einsatz in einem Bogenentladungsverdampfer geeignet, da insbesondere bei den Niedervoltbogenentladungsverdampfern mit Betriebsströmen bis 300 A Probleme bei der elektrischen Kontaktierung des Verdampfungsmaterials auftreten.

Der Erfindung liegt die Aufgabe zugrunde, einen Niedervoltbogenverdampfer mit Nachfütterungseinrichtung der eingangs genannten Art anzugeben, der eine kontinuierliche Vakuumbeschichtung von Substraten bei relativ geringem technischen Aufwand ermöglicht. Eine weitere Aufgabe der Erfindung besteht darin, ein Verfahren zum Einsatz eines derartigen erfindungsgemäßen Niedervoltbogenverdampfers für die kontinuierliche Abscheidung von Misch- oder Legierungsschichten anzugeben.

Die Erfindung löst die Aufgabe bezüglich des Niedervoltbogenverdampfers durch die im kennzeichnenden Teil des Anspruchs 1 genannten Merkmale. Weiterbildungen der Erfindung sind in den Unteransprüchen 2 bis 5 gekennzeichnet. Das Verfahren zur Anwendung des Niedervoltbogenverdampfers löst die Erfindung durch die im kennzeichnenden Teil des Anspruchs 6 genannten Merkmale. Weiterbildungen der Verfahrenserfindung sind in den Unteransprüchen 7 bis 9 gekennzeichnet.

Bei der erfindungsgemäßen Lösung für den Niedervoltbogenverdampfer liegt das anodische Potential unmittelbar an dem stabförmigen Verdampfungsmaterial an, welches im Laufe der Verfahrensführung kontinuierlich in die Verdampfungszone nachgeführt wird. Im Bereich der Verdampfungszone wird das stabförmige Verdampfungsmaterial in einer wassergekühlten Führung gehaltert. Die Führung ist dabei relativ locker, derart, daß das stabförmige Verdampfungsmaterial ungehindert durch die vertikale Bohrung in der Führung geführt werden kann. Die Halterung des stabförmigen Verdampfungsmaterials erfolgt in einer gekühlten Aufnahme, die sich grundsätzlich außerhalb der Vakuumkammer befindet und mit dieser über einen vakuumdichten Metallfaltenbalg elektrisch isoliert verbunden ist. Über die Aufnahme wird das stabförmige Verdampfungsmaterial mit dem anodischen Potential der Niedervoltbogenentladung verbunden. Die Nachführung des stabförmigen Verdampfungsmaterials in die Verdampfungszone erfolgt in an sich bekannter Weise durch manuelle oder motorische axiale Bewegung der Aufnahme, wobei der Metallfaltenbalg entsprechend zusammengedrückt wird.

Die Führung des stabförmigen Verdampfungsmaterials, welche sich innerhalb der Vakuumkammer befindet, ist einschließlich der Kühlwasserleitung gegenüber der Vakuumkammer elektrisch isoliert angeordnet, nimmt beim Betrieb des Verdampfers immer anodisches Potential an, kann zusätzlich elektrisch mit der Anode verbunden sein und ist vollständig mit einem Farraday-Käfig, dessen elektrisches Potential floatet, abgedeckt. Dadurch wird gesichert, daß die Niedervoltbogenentladung nicht gegen diese Führung sondern ausschließlich gegen die Stirnfläche des stabförmigen Verdampfungsmaterials brennt. Zur Vermeidung von Verklemmungen ist es vorteilhaft, die Führung gegenüber der Vakuumkammer im begrenzten Umfang elastisch anzuordnen.

Die eigentliche Nachfütterung des stabförmigen Verdampfungsmaterials in die Verdampfungszone kann nur solange erfolgen, bis der Metallfaltenbalg maximal zusammengedrückt ist. Rechtzeitig vorher wird innerhalb von Wartungsarbeiten das restliche Verdampfungsmaterial nach oben aus der Führung herausgezogen und in die Aufnahme wird ein neuer Stab des Verdampfungsmaterials eingeführt, wobei das bereits vorher verwendete, einseitig eingeschmolzene Endstück des Verdampfungsmaterials wieder als Kopf des neuen Gesamtstabes des Verdampfungsmaterials oben aufgesetzt wird.

Der Vorteil dieses Niedervoltbogenverdampfers mit Nachfütterungseinrichtung besteht dabei insbesondere darin, daß das Verdampfungsmaterial restlos verbraucht wird und die Zündung der Bogenentladung immer gegen eine bereits eingeschmolzene Oberfläche des Verdampfungsmaterials gezündet wird. Des weiteren erfolgt die Verdampfung im Prinzip tiegellos, da der Energieeintrag ausschließlich auf die Stirnfläche des Stabes erfolgt und das Schmelzbad auf den Umfang des Austritts aus der Führung begrenzt bleibt. Verunreinigungen der Schichten durch Tiegelmaterial werden vermieden. Verunreinigungen im Schmelzbad werden aus dem Schmelzbad herausgedrängt und lagern sich am Rand der Führung ab und können von Zeit zu Zeit leicht mechanisch entfernt werden.

Es ist vorteilhaft, wenn die Führung im Bereich der Verdampfungszone konisch aufgeweitet ist. Dadurch wird der obere Abschnitt des Verdampfungsmaterials, gegen den die Bogenentladung brennt, von der Führung nicht unnötig gekühlt. Andererseits wird einem Verklemmen durch thermische Ausdehnung entgegengewirkt. Bei günstiger Dimensionierung bewirkt die thermische Ausdehnung eine zusätzliche Kraftkomponente in Vorschubrichtung.

Der Niedervoltbogenverdampfer kann in vorteilhafter Weise entsprechend des im kennzeichnenden Teil des Anspruchs 6 angegebenen Verfahrens zur Abscheidung von Misch- oder Legierungsschichten auf Substraten eingesetzt werden. Das Querschnittsverhältnis der Stab-Rohr-Kombination richtet sich dabei nach dem gewünschten bzw. erforderlichen Mischungsverhältnis der beiden Materialien. Bei Bedarf können auch Stab-Rohr-Rohr-Kombinationen eingesetzt werden. Das höher schmelzende Material wird vorteilhaft als äußeres Rohr eingesetzt, damit das eingeschmolzene Material in der Verdampfungszone innerhalb des Querschnittes der Stirnfläche der Kombination gehalten werden kann. Von besonderer erfinderischer Bedeutung bei dem Verfahren ist, daß bei Neueinsatz einer Stab-Rohr-Kombination der Verdampfungsmaterialien in die Nachfütterungseinrichtung als Kopfstück jeweils eine bereits eingeschmolzene Stab-Rohr-Kombination verwendet wird, derart, daß die Niedervoltbogenentladung stets gegen den bereits eingeschmolzenen Ingotkopf gezündet wird. Damit wird gesichert, daß von der Zündung an das verdampfende Material immer das gleiche Mischungsverhältnis aufweist. Erfahrungsgemäß kommt es bei Erreichen der Trennstelle zwischen dem alten Kopfstück und der nächstfolgenden Stab-Rohr-Kombination beim Eintritt in die Verdampfungszone zu keiner Änderung des Mischungsverhältnisses im Dampfstrom. Die Verdampfung läuft wie bei einer nicht unterbrochenen Stab-Rohr-Kombination ab.

Die erfindungsgemäße Lösung gestattet sowohl bei Chargen- als auch bei Durchlaufanlagen eine ungehinderte Verdampfung durch permanente Nachfütterung von Verdampfungsmaterial in die Verdampfungszone, wobei insbesondere bei der Verdampfung von unterschiedlichen Verdampfungsmaterialien in Stab-Rohr-Kombinationen konstante Mischungsverhältnisse aufrecht erhalten werden. Bei praktikablen äußeren Stabdurchmessern von 20 bis 30 mm oder größer sowie Faltenbalgwegen von 5 cm und mehr ist eine praktisch kontinuierliche Verdampfung gegeben. Das Bestücken der Nachfütterungseinrichtung mit stabförmigem Verdampfungsmaterial kann in einfacher Weise bei Wartungsarbeiten erfolgen, in dem der bereits eingeschmolzene Stab nach oben aus der Führung herausgenommen wird, ein neuer Stab durch die Führung hindurch in die Aufnahme eingesetzt wird und der bereits stirnseitig eingeschmolzene Stab wieder als Kopfstück auf den neuen eingeführten Stab des Verdampfungsmaterials aufgesetzt wird.

Die Erfindung soll nachstehend an einem Ausführungsbeispiel näher erläutert werden. Die zugehörige Zeichnung zeigt einen Schnitt durch einen erfindungsgemäßen Niedervoltbogenverdampfer mit Nachfütterungseinrichtung.

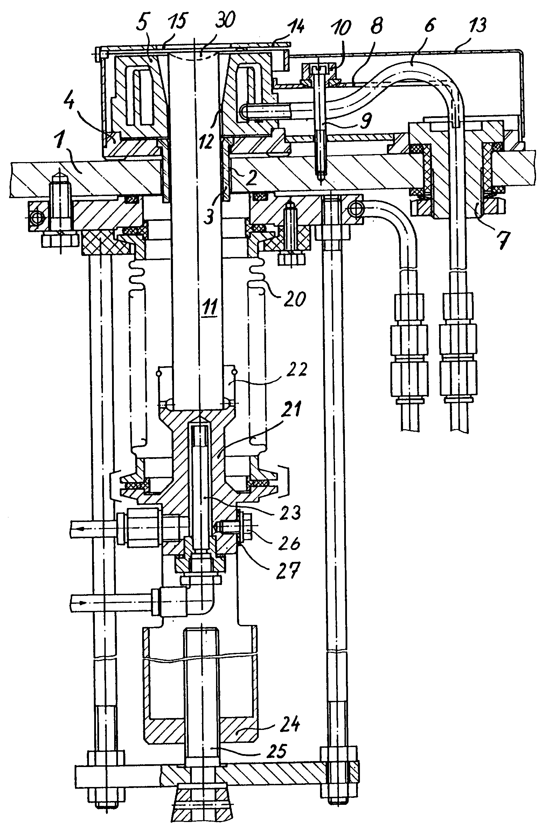

Die Zeichnung zeigt dabei nur die erfindungswesentlichen Teile des Niedervoltbogenverdampfers mit der Nachfütterungseinrichtung. Die sonstigen Bauteile wie Katode und Substratanordnung sind gemäß dem Stand der Technik ausgebildet und nicht dargestellt. Im Boden einer Vakuumkammer 1 befindet sich in einer Durchgangsbohrung 2 ein Keramikring 3, der formschlüssig mit einer Keramikplatte 4 verbunden ist. Die wassergekühlte Führung 5 wird von der Keramikplatte 4 getragen. Die Teile 3, 4 und 5 liegen ohne besondere Verbindung übereinander. Die Kühlwasserzuführung in die Führung 5 erfolgt über die Kühlwasserzu- und abflußleitung 6, die über die Durchführung 7 vakuumdicht aus der Vakuumkammer 1 herausgeführt wird. An der Durchführung 7 ist ein Bügel 8 befestigt, der die seitliche Halterung der Führung 5 realisiert und diese zugleich elastisch gegen den Kammerboden drückt. Der Bügel 8 wird über die Schraube 9 und das Isolierstück 10 gehalten, so daß bei möglichen Verklemmungen des stabförmigen Verdampfungsmaterials 11 in der Bohrung 12 der Führung 5 nicht in unzulässiger Weise vertikal nach oben gedrückt werden kann. Der Keramikring 3 sichert, daß auf der knappen Distanz zwischen dem Kammerboden und dem anodischem Verdampfungsmaterial 11 keine Bogenentladung entstehen kann. Alle Teile des Niedervoltbogenverdampfers, die sich innerhalb der Vakuumkammer 1 befinden, sind mit einem Farraday-Käfig 13 abgedeckt, so daß die Niedervoltbogenentladung ausschließlich gegen die Stirnfläche des Verdampfungsmaterials 11 brennen kann. Vertikal oberhalb der Führung 5 befindet sich eine besondere für den Niedervoltbogen elektrostatisch wirkende Blende 14, die eine für den Dampfaustritt ausreichende Öffnung 15 aufweist.

In vertikaler Richtung unter dem Boden der Vakuumkammer 1 ist isoliert ein Metallfaltenbalg 20 axial zur Bohrung 12 an die Vakuumkammer 1 angeflanscht. Am anderen Ende des Metallfaltenbalges 20 befindet sich eine Aufnahme 21, die stirnseitig einen Stutzen 22 aufweist, in der das stabförmige Verdampfungsmaterial 11 mit ausreichend elektrischem Kontakt eingesteckt ist. Die Aufnahme 21 ist vorteilhaft mit der Kühlwasserführung 23 wassergekühlt. Am unteren Ende besitzt die Aufnahme 21 ein Gewindestück 24, in das ein vertikal feststehend gelagertes Schraubteil 25 eingreift. Durch Drehung des Schraubteils 25 wird das Gewindeteil 24 und damit die gesamte Aufnahme 21 vertikal nach oben bzw. unten bewegt. Das stabförmige Verdampfungsmaterial 11 kann somit durch den Keramikring 3 und die Bohrung 12 hindurch in den Bereich der Verdampfungszone im oberen Teil der Führung 5 geschoben werden. Die Verdampfungszone bildet sich dabei im Bereich der Oberkante der Führung 5 auf der Stirnfläche des stabförmigen Verdampfungsmaterials 11 aus. Wesentlich ist die elektrische Kontaktierung des stabförmigen Verdampfungsmaterials 11 über die Aufnahme 21 mit dem anodischen Potential der Niedervoltbogenentladung. Dazu befindet sich an der Aufnahme 21 eine Klemmschraube 26, die einen Kabelschuh 27 elektrisch mit der Aufnahme 21 verbindet.

Zum Beladen der Nachfütterungseinrichtung mit Verdampfungsmaterial wird die Aufnahme 21 über das Gewindestück 24 und das Schraubteil 25 in eine Mittelstellung gebracht, derart, daß der Metallfaltenbalg 20 etwa zur Hälfte der maximalen Streckung gedehnt ist. Danach wird ein Stab des Verdampfungsmaterials 11 durch die Bohrung 12 und den Keramikring 3 hindurch in den Stutzen 22 eingesetzt. Nachdem das Schraubteil 25 so verstellt worden ist, daß sich die Sirnfläche des Verdampfungsmaterials 11 in der Höhe der Blende 14 liegt, ist der Verdampfer betriebsbereit.

Der so vorbereitete Niedervoltbogenverdampfer kann solange benutzt werden, bis das Verdampfungsmaterial 11 durch den kontinuierlichen Nachschub mittels der Aufnahmeeinrichtung 21 der Metallfaltenbalg 20 maximal zusammengedrückt ist. Ausreichend zeitig vor Erreichen dieses Punktes wird, während üblicher Wartungsarbeiten, der restliche Stab des Verdampfungsmaterials 11 vertikal nach oben aus der Führung 5 herausgezogen. Danach wird die Aufnahme 21 vertikal nach unten bewegt, bis der Metallfaltenbalg 20 sich wieder etwa einer mittleren gestreckten Stellung befindet. Ein neuer Stab des Verdampfungsmaterials 11 wird durch die Führung 5 hindurch in den Stutzen 22 der Aufnahme 21 eingesetzt und der vorher entfernte, bereits genutzte Stabrest des Verdampfungsmaterials 11 wird wieder in die Bohrung 12 der Führung 5 eingesetzt. Mögliche Längendifferenzen der Stäbe gegenüber der Entfernung der Aufnahme 21 zur Verdampfungszone werden durch vertikale Bewegung der Aufnahme 21 nach oben ausgeglichen, bis der neue Stab und der bereits benutzte Stabrest des Verdampfungsmaterials 11 an ihren Stirnflächen dicht aneinander liegen, derart, daß der Stromfluß der Bogenentladung über diese Trennstelle gesichert ist. In der weiteren Folge wird zuerst der bereits benutzte Stabrest des Verdampfungsmaterials 11 verdampft bis nach Erreichen der Trennstelle unmittelbar folgend der neu eingesetzte Stab des Verdampfungsmaterials 11 verdampft wird. Nachfolgend wird die Verwendung des erfindungsgemäßen Niedervoltbogenverdampfers für die kontinuierliche Abscheidung von Misch- und Legierungsschichten an einem Beispiel beschrieben. Es besteht die Aufgabe, eine Titanaluminiumnitridschicht (TiₓAl_{y}N_{z}) auf der Oberfläche von Substraten abzuscheiden. Dazu wird als stabförmiges Verdampfungsmaterial 11 eine Stab-Rohr-Kombination eingesetzt, bei der innerhalb eines Titanrohres ein Aluminiumstab eingesetzt ist. Das Flächenverhältnis der Querschnitte der Stirnflächen beider Materialien ist entsprechend dem geforderten Molvolumenverhältnis bemessen. Bei dieser Verfahrensführung liegt die Stab-Rohr-Kombination der Verdampfungsmaterialien 11 über die Aufnahme 21 am anodischen Potential der Bogenentladung und die Führung 5 nimmt anodisches Potential an. Die Bogenentladung zündet durch die Blende 14 unmittelbar gegen die Stirnfläche der Stab-Rohr-Kombination der Verdampfungsmaterialien 11. Die elektrische Leistung wird mit der Geschwindigkeit, in der die Verdampfungsmaterialien in die Verdampfungszone nachgeschoben werden, derart abgestimmt, daß die maximal mögliche Verdampfungsrate entsprechend der elektrischen Leistung geringfügig höher ist als die nachgeschobene Materialmenge. Mittels dieser Verfahrensführung und insbesondere durch die Anordnung des höher schmelzenden Materials Titan als äußeres Rohr, verbleibt das Schmelzbad 30 innerhalb der Querschnittsfläche der Stab-Rohr-Kombination. Unmittelbar nach dem ersten Einschmelzen handelt es sich bei dem Schmelzbad um eine gleichmäßige Mischung aus den beiden Verdampfungsmaterialien Titan und Aluminium, die auch in der Folge beim fortlaufenden Einschmelzen und durch kontinuierliche Nachführung unverändert aufrecht erhalten wird. Dadurch wird ohne zusätzliche Regelungsmechanismen aus den zwei Materialkomponenten Titanrohr und Aluminiumstab stets ein konstantes Titan-Aluminium-Gemisch verdampft und unter Reaktion mit dem gasförmigen Stickstoff in der Vakuumkammer 1 als homogene TiₓAl_{y}N_{z}-Schicht auf den Substraten abgeschieden.

Der besondere Vorteil der Verwendung des erfindungsgemäßen Niedervoltbogenentladungsverdampfers für die Abscheidung von Misch- und Legierungsschichten durch Verwendung einer Stab-Rohr-Kombination aus Verdampfungsmaterialien besteht darin, daß nach dem bereits beschriebenen Einsetzen von neuem Verdampfungsmaterial unter Wiederverwendung der bereits stirnseitig eingeschmolzenen Stab-Rohr-Kombination die Zündung der Vakuumbogenentladung unmittelbar gegen einen Ingot erfolgt, der aus der erforderlichen Mischung der einzelnen Bestandteile der Verdampfungsmaterialien erfolgt. Zu jeder Zeit der Verdampfung, ausgenommen beim ursprünglichen ersten Einschmelzen, liegt immer eine homogene Mischung der verschiedenen Verdampfungsmaterialien vor. Dabei werden die einzelnen Verdampfungsmaterialien selbst in jeweils reiner Form als Stab-Rohr-Kombination eingesetzt. Gegenüber vielfach beim Stand der Technik eingesetzten Mischtargets, aus z. B. gesintertem Material, ist das eine wesentliche Vereinfachung der Gesamttechnologie mit hohem ökonomischem Effekt.

## Patentansprüche

1. Niedervoltbogenverdampfer für die Beschichtung von Substraten in einer Vakuumkammer mit einer Nachfütterungseinrichtung, die das Verdampfungsmaterial von unten in die Verdampfungszone nachführt, **dadurch gekennzeichnet**, daß eine Führung (5) des Niedervoltbogenverdampfers eine vertikale Bohrung (12) aufweist, in der stabförmiges Verdampfungsmaterial (11) geführt und gehaltert wird, daß die Führung (5) zur Vakuumkammer (1) elektrisch isoliert angeordnet und wassergekühlt ist, daß die Nachfütterungseinrichtung außerhalb der Vakuumkammer (1) angeordnet ist, und in der Achse der Bohrung (12) eine gekühlte Aufnahme (21) für das stabförmige Verdampfungsmaterial (11) aufweist, die über einen Metallfaltenbalg (20) elektrisch isoliert mit der Vakuumkammer (1) mechanisch verbunden ist, und daß das stabförmige Verdampfungsmaterial (11) über die Aufnahme (21) an das anodische Potential der Niedervoltbogenentladung angeschlossen ist.

2. Niedervoltbogenverdampfer nach Anspruch 1, **dadurch gekennzeichnet**, daß die isoliert angeordnete Führung (5), einschließlich der Kühlwasserzu- und ableitung (6), vollständig mit einem Farraday-Käfig (13) abgedeckt ist.

3. Niedervoltbogenverdampfer nach Anspruch 1, **dadurch gekennzeichnet**, daß die Führung (5) an der Vakuumkammer (1) elastisch gehaltert ist.

4. Niedervoltbogenverdampfer nach Anspruch 1, **dadurch gekennzeichnet**, daß die Bohrung (12) der Führung (5) größer ist als der innere Durchmesser des Stutzens (22) in der Aufnahme (21) der Nachfütterungseinrichtung, derart, daß das stabförmige Verdampfungsmaterial (11) fest in den Stutzen (22) eingesetzt und leicht durch die Bohrung (12) hindurch geschoben werden kann.

5. Niedervoltbogenverdampfer nach Anspruch 1, **dadurch gekennzeichnet**, daß die Führung (5) im Bereich der Verdampfungszone konisch aufgeweitet ist.

6. Verfahren zur Abscheidung von Misch- oder Legierungsschichten auf Substrate im Vakuum mit einem Niedervoltbogenverdampfer, der eine Nachfütterungseinrichtung aufweist, die das Verdampfungsmaterial von unten in die Verdampfungszone nachführt, **dadurch gekennzeichnet**, daß verschiedene Verdampfungsmaterialien in Form einer konzentrischen Stab-Rohr-Kombination kontinuierlich in die Verdampfungszone zugeführt werden, und daß die Verdampfungsmaterialien mindestens im Bereich der Verdampfungszone in einer gekühlten Führung (5) geführt werden.

7. Verfahren nach Anspruch 6, **dadurch gekennzeichnet**, daß das höherschmelzende Verdampfungsmaterial als äußeres Rohr der konzentrischen Stab-Rohr-Kombination eingesetzt wird.

8. Verfahren nach Anspruch 6, **dadurch gekennzeichnet**, daß bei Neueinsatz einer Stab-Rohr-Kombination der Verdampfungsmaterialien in die Nachfütterungseinrichtung als Kopfstück eine bereits eingeschmolzene Stab-Rohr-Kombination verwendet wird, derart daß die Niedervoltbogenentladung gegen den bereits eingeschmolzenen Ingotkopf gezündet wird, wobei dieser über Stirnflächenkontakt mit der neu eingesetzten Stab-Rohr-Kombination mit dem anodischen Potential der Niedervoltbogenentladung verbunden wird.

9. Verfahren nach Anspruch 6, **dadurch gekennzeichnet**, daß der kontinuierliche Vorschub des Verdampfungsmaterials so bemessen wird, daß die nachgeschobene Materialmenge pro Zeiteinheit geringfügig kleiner bemessen ist, als die maximal mögliche Verdampfungsrate, die durch die elektrische Leistung der Niedervoltbogenentladung bestimmt ist.
